Europäisches Patentamt

European Patent Office

Office européen des brevets

(19)

(11) Numéro de publication: **0 140 772**
**B1**

(12) **FASCICULE DE BREVET EUROPÉEN**

(45) Date de publication du fascicule du brevet:
**20.07.88**

(21) Numéro de dépôt: **84402018.0**

(22) Date de dépôt: **08.10.84**

(51) Int. Cl.⁴: **H 01 L 29/90,** H 01 L 27/10

(54) Limiteur de puissance élevée à diodes PIN pour ondes millimétriques et procédé de réalisation des diodes.

(30) Priorité: **14.10.83 FR 8316388**

(43) Date de publication de la demande:
**08.05.85 Bulletin 85/19**

(45) Mention de la délivrance du brevet:
**20.07.88 Bulletin 88/29**

(84) Etats contractants désignés:
**DE GB**

(56) Documents cité:
**MICROWAVE JOURNAL, vol. 22, no. 8, août 1979,
pages 59-64, Dedham, US; E.P. VALKENBURG et al.:
"Bulk PIN diode mm waveguide switch & phase
shifter"
MICROWAVE JOURNAL, vol. 26, no. 3, mars 1983,
pages 65-72, Dedham, US; A. ARMSTRONG et al.:
"Millimeter wave high power solid state limiter"**

(73) Titulaire: **THOMSON- CSF, 173, Boulevard
Haussmann, F-75379 Paris Cédex 08 (FR)**

(72) Inventeur: **Henry, Raymond, THOMSON- CSF SCPI
173, bld Haussmann, F-75379 Paris Cedex 08 (FR)**
Inventeur: **Heitzmann, Michel, THOMSON- CSF
SCPI 173, bld Haussmann, F-75379 Paris Cedex 08
(FR)**
Inventeur: **Bouvet, Jean- Victor, THOMSON- CSF
SCPI 173, bld Haussmann, F-75379 Paris Cedex 08
(FR)**

## Description

La présente invention concerne un limiteur de puissance hyperfréquence élevée réalisé à partir de plusieurs diodes PIN au silicium montées dans un guide d'ondes et fonctionnant pour des ondes millimétriques, ainsi qu'un procédé de réalisation de ces diodes.

On rappellera que le but d'un tel dispositif est de transmettre avec une perte minimale de puissance certains signaux hyperfréquence et d'en isoler certains autres.

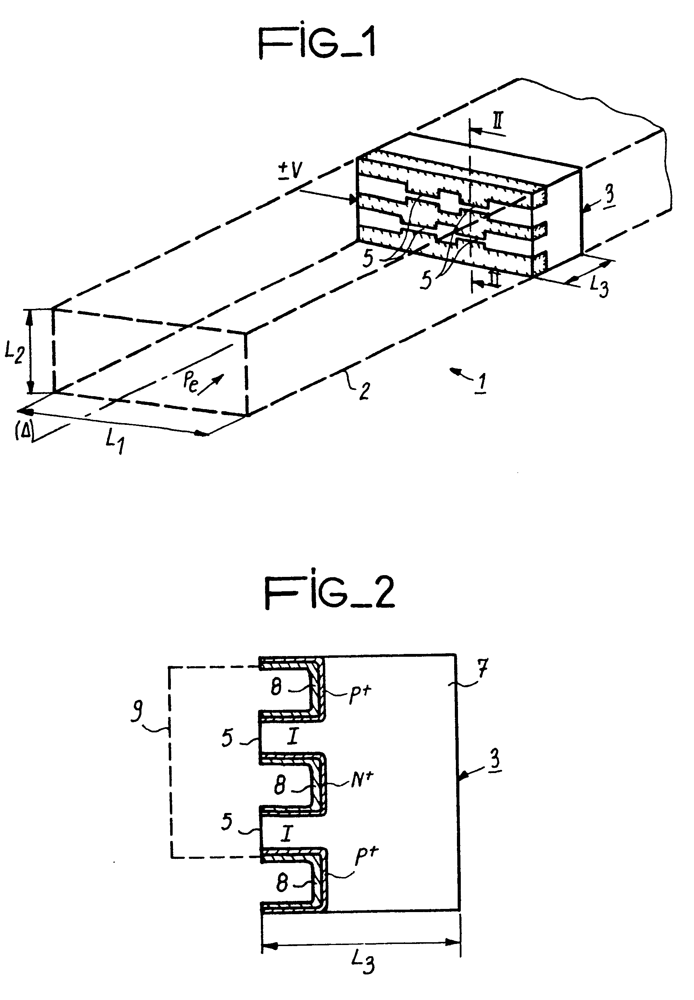

Les figures 1 et 2 représentent respectivement une vue en perspective et une vue en coupe selon la ligne II-II d'une structure connue d'un limiteur de puissance élevée à diodes PIN au silicium pour des ondes millimétriques, tel que décrit dans l'article publié dans "Microwave Journal", mars 1983, pages 65 à 70, intitulé: "Millimeter wave high power solid state limiter". Ce limiteur 1 est constitué par un guide d'ondes 2 rectangulaire métallique, d'axe longitudinal Δ, de dimensions permettant la propagation d'ondes millimétriques, et dans lequel est monté transversalement à l'axe Δ un substrat de silicium 3 se présentant sous forme d'une plaquette ou lame parallélépipédique de section droite rectangulaire de mêmes dimensions que celles de la section droite du guide, soit par exemple $L_1$ = 2,54 mm et $L_2$ = 1,27 mm.

Pour pouvoir supporter une forte puissance hyperfréquence, plusieurs diodes PIN en silicium 5 de mêmes dimensions, par exemple au nombre de quatre, sont réalisées dans la surface du substrat 3 selon une configuration série-parallèle, et sont disposées face à l'entrée de la puissance incidente $P_e$ pour assurer la limitation de celle-ci. Le substrat de silicium 3 présente une dimension $L_3$ selon l'axe longitudinal Δ du guide de l'ordre de 100 μm et obstrue une section transversale du guide 2.

Sur la figure 2, la réalisation des diodes PIN 5 dans la surface du substrat de silicium 3 d'épaisseur $L_3$ de l'ordre de 100 μm est effectué tout d'abord par une attaque de ce dernier de façon à former des sillons de profondeur de l'ordre de 20 μm délimitant les zones de silicium intrinsèque 1 des diodes tout en laissant subsister une épaisse zone 7 de silicium en parallèle sur les zones I des diodes, donc de l'ordre de 80 μm. L'attaque du substrat est suivie de diffusions classiques alternées de type P+ et de type N+ effectuées au niveau des sillons, formant ainsi les zones P+ et N+ des différentes diodes ainsi réalisées. Puis, les sillons sont recouverts de métallisations 8 constituant des contacts sur les zones alternées P+ et N+ des diodes 5 et deux bus métalliques réunissent respectivement les métallisations anodes et cathodes des diodes; seul le bus collectant les métallisations anodes est nécessaire dans l'exemple choisi représenté sur la figure 2 et est repéré par les pointillés 9 sur cette figure. Les diodes PIN 5 sont polarisées par application d'une tension extérieure ± V (figure 1) entre les deux bus métalliques.

Toutefois, un limiteur de puissance élevée pour ondes millimétriques selon cet art antérieur présente des inconvénients. En effet, la présence de la zone de silicium en parallèle sur les zones I des diodes réalisées dans le substrat de silicum crée une traînée des porteurs injectés dans les zones I des diodes, ce qui augmente notablement le temps de commutation des ondes millimétriques se propageant dans le guide d'ondes; par conséquent, ces diodes PIN de commutation ne peuvent être qualifiées de diodes rapides. De plus, cette zone de silicium située en dehors des diodes PIN proprement dites introduit des perte d'insertion supplémentaires à bas niveau et à polarisation nulle.

Pour minimiser les pertes vers le substrat, il est recommandé que la profondeur de creusement des sillons soit égale ou supérieure à la séparation des régions P et N des diodes. Néanmoins, le creusement des sillons ne dépasse pas le quart de l'épaisseur totale du substrat.

Un second articel publié dans "Microwave Journal", août 1979, pages 59 à 64, intitulé "Bulk PIN diode mm waveguide switch and phase shifter" décrit comment un réseau de diodes est obtenu en empilant des rondelles de silicium dopées P sur une face et N sur l'autre face, en soudant ensemble ces rondelles, et en découpant à la scie des tranches dans cet empilement. Ces tranches de diodes servent de commutateur dans un guide d'ondes. Des performances accrues peuvent être obtenues en réduisant la largeur de la région intrinsèque de chaque diode, c'est-à-dire, si l'on tient compte du procédé de fabrication, en réduisant l'épaisseur des rondelles de silicium au départ.

Ces deux articles préconisent donc la même solution, qui consiste en des régions P et N rapprochées, avec une faible épaisseur de silicium intrinsèque entre elles, mais l'épaisseur du limiteur du premier article cité reste de l'ordre de 100 μm, dont 75 % de substrat, et l'épaisseur du commutateur du second article cité est égale à 1,27 mm.

La présente invention a pour but de remédier à ces inconvénients en proposant un limiteur de puissance hyperfréquence élevée pour ondes millimétriques, qui comporte des diodes PIN au silicium assurant une commutation rapide, et présente d'excellentes performances globales au point de vue pertes d'insertion et isolation.

A cet effet, l'invention a pour objet un limiteur de puissance élevée comportant un guide d'ondes rectangulaire d'axe longitudinal, de dimensions permettant la propagation d'ondes millimétriques, et un circuit intégré en silicium de forme parallélépipédique, de section droite rectangulaire sensiblement de mêmes dimensions que celles de la section droite du guide, monté dans le guide transversalement à l'axe longitudinal de celui-ci, et constituant une matrice série-parallèle de diodes PIN de mêmes dimensions, ces diodes étant réalisées dans une pluralité de régions de silicium parallèles, séparées les unes des autres par des sillons et électriquement connectées par une métallisation qui recouvre les flancs des régions de silicium et les fonds des sillons, les zones P+, I et N+ des diodes étant disposées face à l'entrée de la puissance dans le guide, caractérisé en ce que ladite pluralité de régions de silicium forme des barreaux séparés, ces barreaux étant chacun de même longueur que la section droite du circuit et étant rendus solidaires par la métallisation et en ce que la dimension des barreaux de silicium selon l'axe longitudinal du guide d'ondes est égale à celle de la zone I de chacune des diodes selon ce même axe.

On comprend qu'ainsi le fait de donner au substrat une dimension selon l'axe longitudinal du guide égale à celle des zones I des diodes, donc d'éliminer la zone de silicium située en dehors des diodes PIN proprement dites selon l'art antérieur, permet de localiser strictement dans les zones I des diodes l'injection des porteurs; par conséquent, les diodes PIN de commutation sont des diodes rapides qui contribuent à améliorer les pertes d'insertion et l'isolation du limiteur.

L'invention vise également un procédé conçu spécialement pour la réalisation de ces diodes PIN au silicium pour le limiteur selon l'invention.

D'autres caractéristiques et avantages de l'invention apparaîtront mieux dans la description détaillée qui suit, illustrée par les figures suivantes qui, outre les figures 1 et 2 de l'art antérieur déjà décrites, representent:
- la figure 3, une vue en coupe longitudinale du substrat de silicium dans lequel sont réalisées les diodes PIN du limiteur selon l'invention;
- la figure 4, une vue en coupe transversale selon la ligne IV-IV de la figure 3; et
- les figures 5 à 11, des vues en coupe illustrant les différentes étapes du procédé de réalisation des diodes PIN du limiteur selon l'invention.

Sur ces' différentes figures, les mêmes références se rapportent aux mêmes éléments et reprennent celles déjà utilisées pour les mêmes éléments des figures 1 et 2 décrites précédemment.

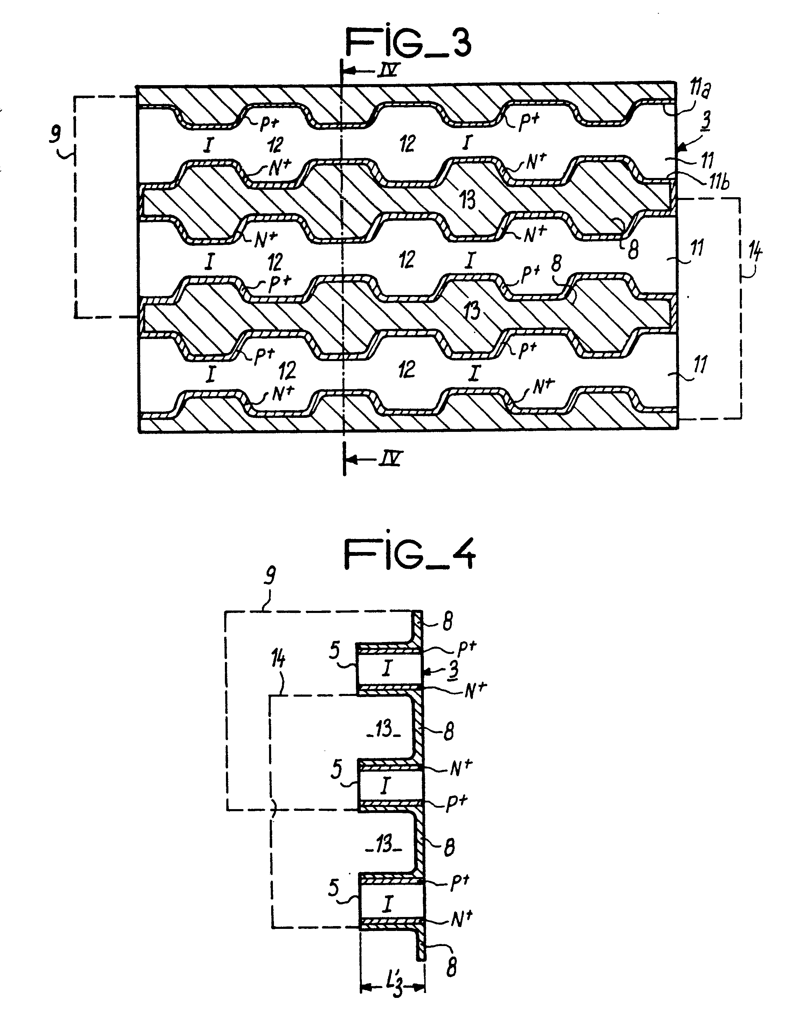

Sur les figures 3 et 4, on a représenté en 3 le substrat de silicium de forme parallélépipédique de section droite rectangulaire destiné à être monté transversalement à l'axe longitudinal du guide d'ondes 2 du limiteur de puissance 1 tel que décrit sur la figure 1, et fonctionnant en ondes millimétriques, par exemple à 94 GHz, et à puissance incidente élevée, par exemple égale à 1 kW.

Dans la surface du substrat 3 est réalisée une matrice de diodes PIN identiques en silicium 5 selon une configuration série-parallèle définie par exemple par trois diodes en série dans chacune des quatre colonnes en parallèle; soit au total douze diodes. Chacune des diodes PIN au silicium 5 est constituée par une zone ou région de silicium intrinsèque I disposée entre deux zones ou régions dopées respectivement P+ et N+, et la zone I de chaque diode 5 est formée à même le substrat de silicium 3.

Comme il apparaît sur la figure 4, le substrat 3 présente une dimension $L'_3$ selon l'axe longitudinal du guide d'ondes 2 de la figure 1, égale à celle de la zone I de chacune des diodes 5, soit par exemple 25 μm. Ceci a pour avantage de localiser l'injection des porteurs dans une bande de silicium strictement définie par les zones I des diodes, ce qui améliore notablement le temps de commutation car les porteurs n'ont désormais plus la possibilité d'avoir de traînée dans une zone de silicium en parallèle sur les zones I des diodes PIN.

A titre illustratif, la couche I de chaque diode 5 est de faible épaisseur, de l'ordre de 5 à 20 μm, et les couches P+ et N+ de chaque diode sont très minces, de l'ordre de 2 μm chacune.

Sur la figure 3 qui représente une vue de face coupée du substrat de silicium 3, ce dernier se compose, selon sa section droite rectangulaire, de plusieurs barreaux identiques de silicium 11, au nombre de trois dans l'exemple choisi de la configuration série-parallèle des diodes PIN, disposés parallèlement à la longueur de là section droite du substrat et sur toute la hauteur de cette section droite.

Chaque barreau de silicium 11 s'étend longitudinalement sur toute la face avant du substrat, c'est-à-dire celle destinée à recevoir la puissance d'entrée du limiteur, et comporte deux bords longitudinaux opposés 11a et 11b présentant l'un par rapport à l'autre une forme de créneaux identiques opposés à flancs respectifs légèrement inclinés, réalisant ainsi des parties de silicium alternativement rétrécies et élargies. Les parties rétrécies de chaque barreau 11, au nombre de quatre dans l'exemple choisi de la configuration série-parallèle des diodes PIN, constituent les zones I des diodes 5, tandis que les parties élargies de chaque barreau, repérées en 12, assurent une réduction de la capacité parasite.

Sur la hauteur du substrat 3, les barreaux de silicium 11 sont délimités ou séparés les uns des autres par des sillons 13 épousant chacun longitudinalement la forme en créneaux des barreaux et présentant donc chacun en coupe sur la figure 4 une forme de U dont les flancs ou parois opposées parallèles délimitent les diodes 5 et dont le fond se situe au niveau de la face arrière du substrat 3. Chaque sillon 13 présente, sur la figure 4, une profondeur égale à la dimension $L'_3$ de chaque diode PIN 5.

Les zones P+ et N+ des diodes 5 sont disposées longitudinalement et en alternance chacune uniquement sur les deux parois opposées d'un même sillon 13, c'est-à-dire en fait sur les deux bords opposés d'un même barreau de silicium II constituant ainsi les diverses diodes PIN au silicium 5.

Les sillons 13 sont de plus recouverts respectivement de couches métalliques 8 constituées chacune par exemple d'un ensemble de sous-couches de titane, platine et or, formant ainsi des métallisations des zones alternées P+ et N+ des diodes 5. De plus, les métallisations anodes et cathodes 8 des diodes PIN 5 sont toutes reliées respectivement à deux connexions communes ou bus métalliques, par exemple en or, repérées en 9 et 14 par les pointillés sur les figures 3 et 4.

Le substrat de silicium 3 décrit ci-dessus, et dans la surface duquel est réalisée la matrice de diodes PIN 5, est monté dans le guide d'ondes 2 de la figure 1 de façon à obstruer une section transversale de celui-ci, l'ensemble guide d'ondes 2-diodes PIN 5 formées dans le substrat, constituant le limiteur de puissance repéré en 1 sur la figure 1 et dont le fonctionnement est le suivant.

Lorsque les diodes PIN sont bloquées, le guide d'une part peut être considéré comme rempli d'un matériau diélectrique de constante diélectrique ε élevée et d'autre part a des dimensions telles que la propagation d'une onde millimétrique est possible. Dans ce cas, la puissance incidente est transmise avec un minimum de perte par le limiteur.

Par contre, lorsque les diodes PIN conduisent, elles sont équivalentes à un court-circuit et une grande partie de la puissance incidente est réfléchie par le limiteur, isolant ainsi sa sortie de son entrée.

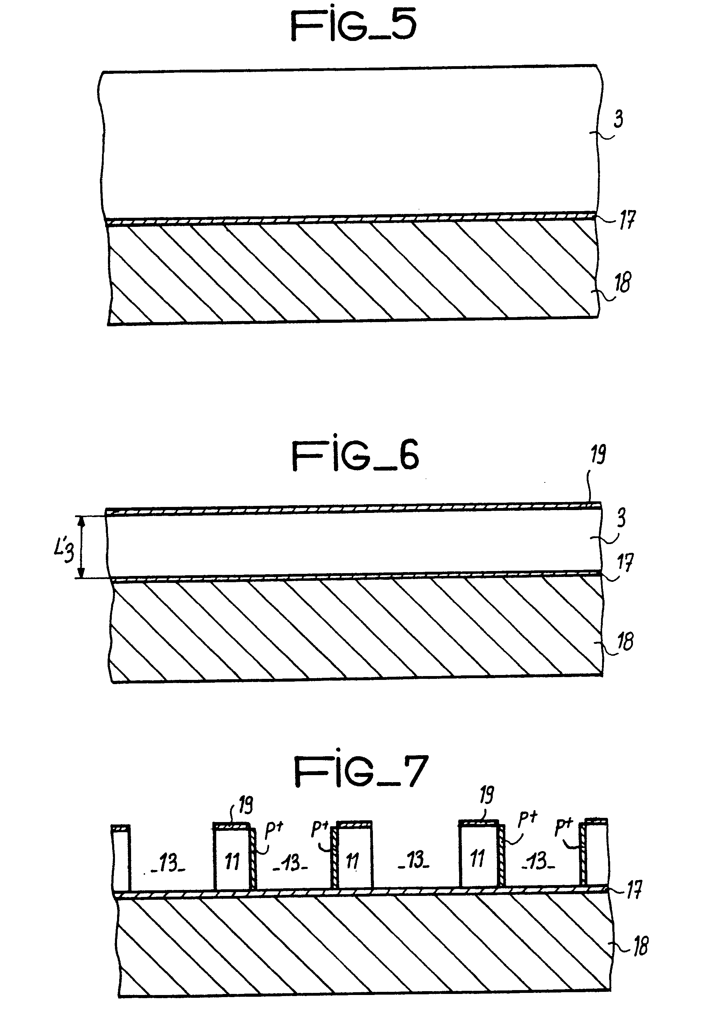

On va maintenant décrire en référence aux figures 5 à 11, un procédé de réalisation ou fabrication des diodes PIN au silicium selon une configuration série-parallèle formée dans le substrat de silicium 3 tel que représenté sur les figures 3 et 4.

Chacune des opérations utilisées dans ce procédé est en soi connue. Ce qui fait la différence par rapport au procédé utilisé pour le limiteur décrit dans Microwave Journal, mars 1983, pages 65 à 70 cite plus haut est qu'il faut d'abord consolider la rondelle de substrat silicium par un support mécanique pour pouvoir ensuite amincir le substrat jusqu'à 20-25 μm d'épaisseur, avant de supprimer le support mécanique.

Selon un mode de réalisation préféré, ce procédé est mis en oeuvre à partir d'un substrat de silicium pur 3 se présentant sous forme d'une rondelle d'épaisseur d'environ 100 μm, possédant une haute résistivité, de l'ordre de 4000 Ωcm, et ayant un diamètre tel qu'il soit possible d'élaborer un nombre donné de diodes PIN qui donneront, après découpes selon des matrices déterminées, des substrats élémentaires du type représenté sur les figures 3 et 4.

La première étape du procédé de réalisation des diodes PIN, représentée sur la figure 5, consiste à déposer une couche d'arrêt 17, d'épaisseur d'environ 1 μm, sur le substrat de silicium 3. Cette couche d'arrêt peut être réalisée par exemple en oxyde de silicium SiO₂ obtenu par oxydation thermique du substrat de silicium. Puis, dans un réacteur classique, une couche de silicium polycristallin 18 est déposée sur la couche d'arrêt 17 sur une épaisseur de l'ordre de 100 μm.

Cette couche épaisse 18 va servir de support mécanique pour pouvoir réaliser la seconde étape du procédé qui consiste, comme représenté sur la figure 6, à amincir le substrat de silicium 3 à une repaisseur donnée L'₃ d'environ 25 μm par un procédé connu, mécano-chimique par exemple. Une couche 19, d'environ 1 μ d'épaisseur, par exemple en oxyde de silicium SiO₂ est ensuite déposée sur le substrat de silicium 3 considérablement aminci.

On notera que l'avantage de la couche d'arrêt 17 déposée entre le substrat 3 et la couche épaisse en silicium polycristallin 18 réside dans le fait qu'une attaque chimique réalisée ultérieurement sur la face arrière, cèst-à-dire une attaque de la couche 18 en direction du substrat 3, s'arrêtera sur la couche 17.

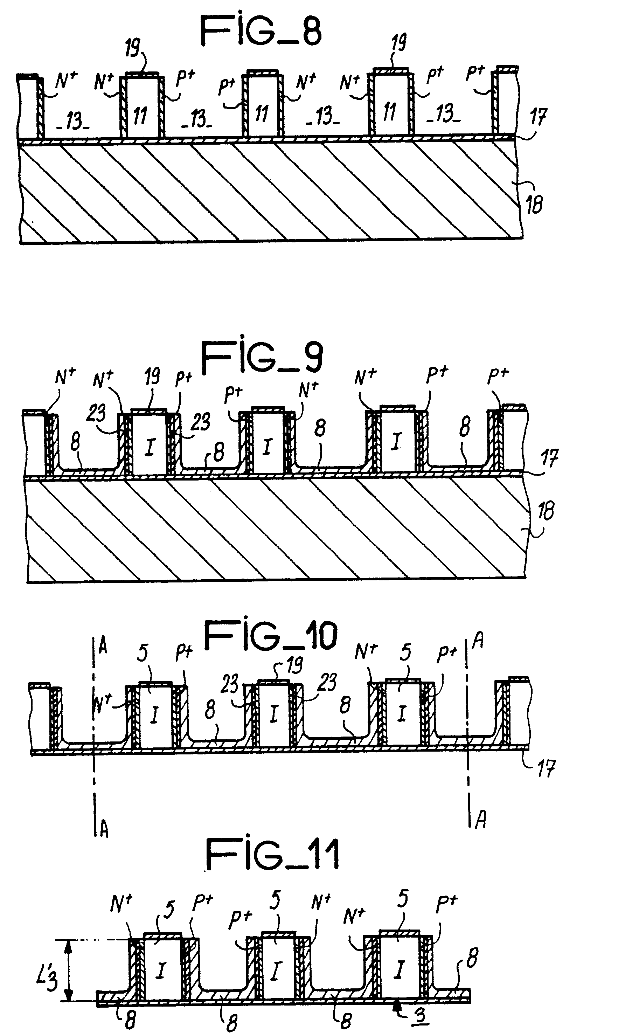

Les deux étapes suivantes, représentées sur les figures 7 et 8, consistent en des diffusions classiques alternées de silicium dopé de type P+ et de type N+ en utilisant une technique de masquages successifs de façon à réaliser les diodes PIN au silicium proprement dites.

A cet effet, sur la figure 7, le substrat de silicium aminci est tout d'abord attaqué, par exemple par photogravure, jusqu'à la couche d'arrêt 17 de façon à former des sillons 13 délimitant des barreaux identiques de silicium 11. Les parois latérales de chaque sillon 13 présentent, dans un plan perpendiculaire au plan de coupe de la figure 7, et l'une par rapport à l'autre, une forme de créneaux identiques opposés tels que représenés sur la figure 3. Chaque barreau 11 présente donc, toujours dans un plan perpendiculaire au plan de coupe de la figure 7, des parties alternativement rétrécies et élargies telles que représentées sur la figure 3, les parties rétrécies de chaque barreau constituant les zones I, d'épaisseur de l'ordre de 5 à 20 μm, des futures diodes.

On procède ensuite à une oxydation de tous les sillons 13 ainsi formés, puis on désoxyde un sillon sur deux et, sur la figure 7, on effectue une diffusion de silicium dope de type P+ sur les parois des sillons désoxydés, formant ainsi les zones P+, d'épaisseur de l'ordre de 2 μm, des futures diodes PIN.

Puis, on désoxyde les sillons restants, c'est-à-dire les sillons non désoxydés lors de la diffusion de type P+, et, sur la figure 8, on effectue une diffusion de silicium dopé de type N+ sur les parois des sillons restants une fois désoxydés, formant ainsi les zones N+, d'épaisseur de l'ordre de 2 μm, des diodes PIN.

L'étape suivante, représentée sur la figure 9, consiste à metalliser tous les sillons 13 uniquement au niveau des parois et du fond de chacun d'eux, soit par photogravure soit par une technique de lift-off, après désoxydation des zones diffusées P+ et N+. Cette métallisation consiste à déposer d'abord sur chaque zone P+ et N+ une couche 23 de platine et de former du siliciure de platine par traitement thermique destiné à constituer un contact ohmique. Cette métallisation est ensuite complétée par des dépôts successifs sur tout le profil de chaque sillon de titane (par exemple 50 μm (500 Å)), de platine (par exemple 100 μm (1000 Å)) et d'or (par exemple 500 μm (5000 Å)). On a représenté par chaque couche 8 sur la figure 9 l'ensemble des dépôts titane-platine-or.

On notera que la structure ainsi obtenue peut être renforcée mécaniquement par une croissance électrolytique d'or de chaque couche de métallisation 8.

L'étape suivante, représentée sur la figure 10, consiste à éliminer la couche de silicium polycristallin 18 par exemple par une attaque chimique jusqu'a la couche d'arrêt 17.

On procède ensuite à la séparation des différentes matrices de diodes PIN 5 par des découpes carrées ou rectangulaires réalisées de façon classique au niveau des métallisations 8, comme représenté par les traits mixtes AA sur la figure 10. Ces découpes sont facilitées en réalisant des sillons beaucoup plus larges au niveau de la séparation proprement dite.

La figure 11 représente le substrat élémentaire 3 tel que représenté sur la figure 4 pour le limiteur de puissance selon l'invention, après une découpe rectangulaire de la matrice de diodes PIN 5 selon la configuration série-parallèle définie dans l'exemple choisi par trois diodes en série dans chacune des quatre colonnes en parallèle. Sur la figure 11, l'épaisseur $L'_3$ du substrat de silicium 3 correspond donc à la dimension de celui-ci selon l'axe longitudinal du guide d'ondes, une fois le substrat monté transversalement dans le guide.

## Revendications

1. Limiteur de puissance élevée comportant un guide d'ondes (2) rectangulaire d'axe longitudinal (Δ), de dimensions permettant la propagation d'ondes millimétriques, et un rcuit intégré (3) en silicium de forme parallélépipédique, de section droite rectangulaire sensiblement de mêmes dimensions que celles de la section droite du guide, monté dans le guide transversalement à l'axe longitudinal de celui-ci, et constituant une matrice série-parallèle de diodes PIN (5) de mêmes dimensions, ces diodes étant réalisées dans une pluralité de régions de silicium parallèles, séparées les unes des autres par des sillons et électriquement connectées par une métallisation (8) qui recouvre les flancs des régions de silicium et les fonds des sillons, les zones P+, I et N+ des diodes étant disposées face à l'entrée de la puissance dans le guide, caractérisé en ce que ladite pluralité de régions de silicium forme des barreaux (11) séparés, ces barreaux étant chacun de même longueur que la section droite du circuit et étant rendus solidaires par la métallisation (8) et en ce que la dimension ($L_3'$) des barreaux de silicium selon l'axe longitudinal (Δ) du guide d'ondes est égale à celle de la zone I de chacune des diodes selon ce même axe (Δ).

2. Limiteur selon la revendication 1, caractérisé en ce que la dimension ($L'_3$) des barreaux de silicium (11) selon l'axe longitudinal (Δ) du guide d'ondes est de l'ordre de 25 μm.

3. Limiteur selon l'une des revendications 1 ou 2, caractérisé en ce que les deux flancs longitudinaux opposés (11a, 11b) de chaque barreau présentent l'un par rapport à l'autre une forme de créneaux identiques opposés, formant ainsi des parties de silicium alternativement rétrécies et élargies, les parties rétrécies des barreaux constituant les zones I des diodes PIN (5), les parties élargies (12) des barreaux constituant des zones de réduction de capacité entre diodes PIN (5).

4. Limiteur selon la revendication 3, caractérisé en ce que les zones P+ et N+ des diodes PIN (5) sont disposées en alternance chacune sur les deux flancs opposés d'un même sillon (13) séparant deux barreaux de silicium, les zones P+ et N+ ayant chacune une dimension selon l'axe longitudinal (Δ) du guide égale à celle de la zone I de chacune des diodes PIN (5) selon ce même axe.

5. Limiteur selon la revendication 4, caractérisé en ce que la métallisation (8) comporte des couches métalliques constituant des contacts sur les zones alternées P+ et N+ des diodes PIN, en ce que les couches métalliques des zones P+ sont toutes reliées à une première connexion commune métallique (9), et en ce que les couches métalliques des zones N+ sont toutes reliées à une seconde connexion commune métallique (14).

6. Procédé de réalisation de diodes PIN au silicium selon une configuration série-parallèle pour un limiteur de puissance élevée comportant un guide d'ondes rectangulaire d'axe longitudinal et de dimensions permettant la propagation d'ondes millimétriques, comportant, à partir d'un substrat de silicium (3), les étapes suivantes:

a) un dépôt d'une couche d'arrêt de silice (17) puis d'une couche épaisse de silicium polycristallin (18) sur l'une des deux faces opposées parallèles du substrat, formant ainsi un support pour le substrat ;

b) un amircissement du substrat (3) à une épaisseur donnee ($L'_3$);

c) une attaque du substrat de silicium (3) sur toute son épaisseur de façon à former des sillons (13) délimitant ainsi des barreaux (11) longitudinaux identiques de silicium, chaque sillon (13) ayant deux flancs opposés présentant longitudinalement l'un par rapport à l'autre une forme de creneaux identiques opposes, de sorte que chaque barreau (11) présente longitudinalement des parties alternativement rétrécies et élargies, les parties rétrécies des barreaux constituant les zones I des diodes;

d) une première diffusion de silicium dopé de type P+ réalisée un sillon sur deux et sur chacun des deux flancs opposés d'un même sillon, formant ainsi les zones P+ des diodes;

e) une seconde diffusion de silicium dopé de type N+ réalisée pour chaque sillon restant une fois l'étape précédente effectuée et sur chacun des deux flancs opposés d'un même sillon restant, formant ainsi les zones N+ des diodes;

f) un recouvrement métallique de tous les sillons (3) de la structure complexe obtenue à l'étape précédente;

g) un retrait de la couche de silicium polycristallin formant support (18); et

h) une découpe d'un ensemble donné de plusieurs barreaux de silicium (11) effectuée au niveau des recouvrements métalliques délimitant cet ensemble de barreaux, permettant ainsi d'obtenir une matrice de diodes PIN (5) de configuration série-parallèle.

7. Procédé selon la revendication 6, caractérisé en ce que le dépôt d'une couche d'arrêt (17) est réalisé par oxydation thermique du substrat de silicium.

8. Procédé selon l'une des revendications 6 à 7, caractérisé en ce que l'amincissement du substrat de silicium (3) est à une épaisseur d'environ 25 µm.

## Patentansprüche

1. Begrenzer für hohe Leistung mit einem rechteckigen, eine Längsachse (Δ) aufweisenden Wellenleiter (2), derart bemessen ist, daß er die Ausbreitung von Millimeterwellen ermöglicht, und mit einer quaderförmigen Silizium-Integrierschaltung (3) von rechteckigem Querschnitt, die im wesentlichen die gleichen Abmessungen wie diejenigen des Leiterquerschnitts aufweist und quer zur Längsachse desselben in dem Leiter gelagert ist, wobei sie eine Serie/Parallel-Matrix aus PIN-Dioden (5) mit denselben Abmessungen bildet, wobei diese Dioden in einer Mehrzahl von parallelen Silizium-Dereichen verwirklicht sind, welche durch Rillen voneinander getrennt und durch eine Metallisierung (8) elektrisch verbunden sind, die die Flanken der Siliziumbereiche und die Böden der Rillen überlappt, wobei die Zonen P+, I und N+ der Dioden gegenüber dem Leistungseingang in dem Leiter angeordnet sind, dadurch gekennzeichnet, daß die obengenannte Mehrzahl der Siliziumbereiche getrennte Stäbe (11) bildet, wobei jeder dieser Stäbe dieselbe Länge wie der senkrechte Querschnitt der Schaltung aufweist und wobei sie durch die Metallisierung (8) miteinander verbunden sind, und daß die Abmessung (L₃') der Siliziumstäbe entlang der Längsrichtung (Δ) des Wellenleiters derjenigen der Zone I jeder der Dioden derselben Achse (Δ) entlang entspricht.

2. Begrenzer nach Anspruch 1, dadurch gekennzeichnet, daß die Abmessung (L'₃) der Siliziumstäbe (11) entlang der Längsachse (Δ) des Wellenleiters in der Größenordnung von 25 µm liegt.

3. Begrenzer nach einem der Ansprüche 1 oder 2, dadurch gekennzeichnet, daß die beiden entgegengesetzten Längsflanken (11a, 11b) jedes Stabes in Bezug auf einander eine Form von identischen, entgegengesetzten Zinken aufweisen und so Siliziumteile bilden, die abwechselnd verengt und verbreitert sind, wobei die verengten Teile der Stäbe die Zonen I des PIN-Dioden (5) und die verbreiteten Teile (12) der Stäbe Zonen zur Reduktion der Kapazität zwischen den PIN-Dioden (5) bilden.

4. Begrenzer nach Anspruch 3, dadurch gekennzeichnet, daß jede der Zonen P+ und N+ der PIN-Dioden (5) abwechselnd auf den beiden entgegengesetzten Flanken einer selben Rille (13) angeordnet sind, die zwei Siliziumstäbe voneinander trennt, wobei jede der Zonen P+ und N+ eine Abmessung entlang der Längsachse (Δ) des Leiters aufweist, die derjenigen der Zone I jeder der PIN-Dioden (5) entlang derselben Achse entspricht.

5. Begrenzer nach Anspruch 4, dadurch gekennzeichnet, daß die Metallisierung (8) Metall schichten umfaßt, die Kontakte auf den abwechselnden Zonen P+ und N+ der PIN-Dioden bilden, daß alle Metall schichten der Zonen P+ mit einer ersten gemeinsamen Metallverbindung (9) verbunden sind und daß alle Metallschichten der Zonen N+ mit einer zweiten gemeinsamen Metallschicht (14) verbunden sind.

6. Herstellungsverfahren für Silizium-PIN-Dioden nach einer Serie/Parallel Konfiguration für einen Begrenzer für hohe Leistung, mit einem rechteckigen, eine Längachse aufweisenden Wellenleiter, dessen Abmessungen die Ausbreitung von Millimeterwellen ermöglicht, und ausgehend von einem Siliziumsubstrat, die folgenden Schritte umfassend:

a) einen Überzug aus einer Silizium-Sperrschicht (17) sowie eine dicke polykristalline Siliziumschicht (18) auf einer der beiden entgegengesetzten parallelen Fläche des Substrats, wobei ein Träger für das Substrat auf diese Weise gebildet wird;

b) eine Verjüngung des Substrats (3) auf eine vorbestimmte Dicke (L'₃);

c) eine Bearbeitung des Silizium-Substrats (3) über seine gesamte Dicke, so daß Rillen (13) gebildet werden, die auf diese Weise identische Längsstäbe (11) aus Silizium voneinander trennen, wobei jede Rille (13) zwei entgegengesetzte Flanken umfaßt, die in Längsrichtung und in Bezug aufeinander eine Form von identischen, entgegengesetzten Zinken aufweisen, so daß jeder Stab (11) in Längsrichtung Teile aufweist, die abwechselnd verengt und verbreitert sind, wobei die verengten Teile der Stäbe die Zonen I der Dioden bilden;

d) eine erste Diffusion mit dotiertem Silizium des Typs P+, die auf einer von zwei Rillen und auf jeder der zwei entgegengesetzten Flanken einer selben Rille vorgenommen wird, wobei die Zonen P+ der Dioden auf diese Weise gebildet werden;

e) eine zweite Diffusion mit dotiertem Silizium des Typs N+, die für jede bleibende Rille nach der Verwirklichung des vorstehenden Schrittes und auf jeder der zwei entgegengesetzten Flanken einer selben bleibenden Rille verwirklicht wird, wobei die Zonen N+ der Dioden auf diese Weise gebildet werden;

f) einen Metallüberzug aller Rillen (3) der komplexen Struktur, die man bei dem vorstehenden Schritt erhält;

g) eine Entfernung der polykristallinen Siliziumschicht, die den Träger (18) bildet;

h) ein Ausschneiden einer vorbestimmten Gruppe aus mehreren Siliziumstäben (11), das an den Metallüberzügen, die diese Gruppe von Stäben abgrenzen, vorgenommen wird, wobei eine Matrix aus PIN-Dioden (5) mit einer Serie/Parallel-Konfiguration auf diese Weise erhalten wird.

7. Verfahren nach Anspruch 6, dadurch gekennzeichnet, daß der Überzug mit einer Sperrschicht (17) durch eine thermische Oxidierung des Silizium-Substrats ausgeführt wird.

8. Verfahren nach einem der Ansprüche 6 bis 7, dadurch gekennzeichnet, daß die Verjüngung des Silizium-Substrats (3) auf eine Dicke von ca. 25 µm erfolgt.

**Claims**

1. A high power limiter comprising a rectangular wave guide (2) with a longitudinal axis ($\Delta$), with dimensions permitting the propagation of millimetric waves, and a silicon integrated circuit (3) having a parallelepipedon form, with a perpendicular rectangular section substantially of the same dimensions as those of the perpendicular section of the guide, mounted in the guide transversally in relation to the longitudinal axis of the same, and constituting a series-parallel matrix of PIN diodes (5) with the same dimensions, such diodes being made in a plurality of parallel silicon regions, separated from each other by furrows and electrically connected by a metallisation (8) which covers the flanks of the silicon regions and the flood of the furrows, the P+, I and N+ of the diodes being placed facing the entrance of the power into the guide, characterized in that the said plurality of silicon regions forms separate rods (11), such rods being each of the same length as the perpendicular section of the circuit and being integrated by the metallisation (8) and in that the dimension ($L_3'$) of the silicon along the longitudinal axis ($\Delta$) of the wave guide is equal to the that of the I zone of each of the diodes along the same axis ($\Delta$).

2. The limiter as claimed in claim 1 characterized in that the dimensions ($L'_3$) of the silicon rods (11) along the longitudinal axis ($\Delta$) of the wave guide is of the order to 25 microns.

3. The limiter as claimed in claim 1 or claim 2 characterized in that the two opposite longitudinal flanks (11a and 11b) of each rod present in relation to each other the form of opposite identical crenelations thus forming silicon parts which are alternatively protruding and withdrawn, the withdrawn parts of the rods constituting the I zones of the PIN diodes (5), the protruding parts (12) of the rods constituting the capacity reduction zones between PIN diodes (5).

4. The limiter as claimed in claim 3 characterized in that the P+ and N+ zones of the PIN diodes (5) are alternatingly placed, each being on the two opposite flanks of a given furrow (13) separating two silicon rods, the P+ and N+ zones each having a dimension along the longitudinal axis ($\Delta$) of the guide equal to that of the I zone of the PIN diodes (5) along this same axis.

5. The limiter as claimed in claim 4 characterized in that the metallisation (8) comprises metallic layers constituting the contacts on the alternating P+ and N+ zones of the PIN diodes, in that the metallic layers of the P+ zones are linked with a first metallic common connection (9) and in that the metallic layers of the N+ zones are all connected with a second metallic common connection (14).

6. A process for the manufacture of silicon PIN diodes in accordance with a series parallel configurations for a high power limiter comprising a rectangular wave guide with a longitudinal axis and with dimensions permitting the propagation of millimetric waves, comprising, starting with a silicon substrate (3), the following steps:

a) the deposit of a silicon dioxide barrier layer (17) and then of a thick layer of polycrystalline silicon (18) on one of the two opposite parallel faces of the substrate, thus forming a support for the substrate;

b) reduction of the substrate (3) to a given thickness ($L'_3$);

c) action on the silicon substrate (3) over all its thickness in order to form furrows (13) thus delimiting longitudinal identical silicon rods (11), each furrow (13) having two opposite flanks presenting longitudinally in relation to each other a configuration of identical opposite crenelations so that each rod (11) longitudinally presents alternately withdrawn and protruding parts of the rods constituting the 1 zones of the diodes;

d) a first diffusion of doped silicon of the P+ type implemented at one of two furrows and on each of the opposite flanks of the same furrow, thus forming the P+ zones of the diodes;

e) a second diffusion of doped silicon of the N+ type realized for each furrow remaining once in the preceding step effected and on each of the two opposite flanks of the same remaining furrow, thus forming the N+ zones of the diodes;

f) a metallic covering of all the furrows (3) of the complex structure of the preceding step;

g) a withdrawal of the layer of polycrystalline silicon forming a support (18); and

h) severing the assembly formed by several rods of silicon (11) effected at the level of the metallic coverings delimiting this assembly of rods, this permitting the production of a matrix of PIN diodes (5) in a series-parallel configuration.

7. The method as claimed in claim 6 characterized in that the deposit of a barrier layer (17) is performed by the thermal oxidation of the silicon substrate.

8. The method as claimed in claims 6 and 7 characterized in that the reduction of the silicon substrate (3) takes place down to a thickness of approximately 25 microns.

0 140 772

# FIG_1

# FIG_2

1

# FIG_3

# FIG_4

## FIG_5

3

17

18

## FIG_6

19

3

$L'_3$

17

18

## FIG_7

19

P+  P+  19  P+  P+

_13_  11  _13_  11  _13_  11  _13_

17

18

## FIG_8

N⁺ N⁺ 19 P⁺ P⁺ 19 N⁺ N⁺ 19 P⁺ P⁺
_13_ 11 _13_ 11 _13_ 11 _13_ 17
18

## FIG_9

N⁺ N⁺ 19 P⁺ P⁺ N⁺ N⁺ P⁺ P⁺
23 23
8 I 8 I 8 I 8
17
18

## FIG_10

A 5 P⁺ 19 N⁺ 5 P⁺ A
N⁺ 23 23 8
8 I I 8 I
17
A A

## FIG_11

N⁺ 5 P⁺ P⁺ 5 N⁺ N⁺ 5 P⁺
L'₃ I I I 8
8 8 8 3

7